Europäisches Patentamt

European Patent Office

Office européen des brevets

(19)

(11)  **EP 1 257 054 B1**

(12)  **FASCICULE DE BREVET EUROPEEN**

(45) Date de publication et mention
de la délivrance du brevet:
**13.12.2006   Bulletin 2006/50**

(51) Int Cl.:
***H03G 3/30*** (2006.01)

(21) Numéro de dépôt: **02290938.6**

(22) Date de dépôt: **15.04.2002**

(54) **Dispositif de régulation du contrôle de la puissance d'un émetteur**

Vorrichtung zur Leistungsregelung eines Senders

Power controlling device for a transmitter

(84) Etats contractants désignés:
**AT BE CH CY DE DK ES FI FR GB GR IE IT LI LU
MC NL PT SE TR**

(30) Priorité:  **07.05.2001  FR 0106072**

(43) Date de publication de la demande:
**13.11.2002   Bulletin 2002/46**

(73) Titulaire: **TCL & ALCATEL MOBILE PHONES
LIMITED
China Hong Kong City,
33 Canton Road,
Tsim Sha Tsui,Kowloon,
Hong Kong (CN)**

(72) Inventeurs:
• **Lagoguez, Bruno
38640 Claix (FR)**
• **Brigaud, Jean Claude
95770 Montreuil sur Epte (FR)**
• **Pouliquen, Mikael
75015 Paris (FR)**

(74) Mandataire: **Feray, Valérie et al
Feray Lenne Conseil
39/41, avenue Aristide Briand
92163 Antony (FR)**

(56) Documents cités:
**EP-A- 0 434 294          US-A- 5 150 075**

EP 1 257 054 B1

**Description**

La présente invention se rapporte au domaine des transmissions de signaux radiofréquence et concerne plus particulièrement un dispositif d'émission de signaux radiofréquence comprenant des moyens d'amplification de puissance destinés à amplifier la puissance du signal radiofréquence reçu à une entrée desdits moyens d'amplification, des moyens de contrôle du gain desdits moyens d'amplification pour réguler ledit gain de manière à ce que la puissance du signal de sortie desdits moyens d'amplification tende vers une valeur nominale désirée.

Dans un système de télécommunications reliant un terminal mobile à une station de base, il faut assurer une qualité de service minimale. Par exemple, dans le cas d'une transmission de signaux numériques, cette condition requiert que le taux d'erreurs binaires soit toujours inférieur à un taux requis. Pour satisfaire à cette condition en réception, on s'assure qu'à tout instant, le rapport signal à bruit reçu soit supérieur à une valeur prédéterminée.

Le problème que vise à résoudre l'invention est d'attribuer, à chaque communication, du terminal vers la station de base qui lui est dédiée, une ressource en puissance qui soit telle que cette puissance soit celle juste nécessaire pour que le rapport signal à bruit réponde aux spécifications. Ainsi, les communications auront une qualité de service requise garantissant un taux d'erreurs binaires inférieur à une limite prédéterminée sans consommation excessive de puissance. En effet, la puissance émise doit celle qui est juste nécessaire, car la puissance disponible dans le terminal est limitée.

Pour permettre une montée en puissance du signal à émettre, le terminal mobile est pourvu d'un amplificateur de puissance ("power amplifier" en langue anglaise). En communication, cet amplificateur de puissance a pour objectif d'émettre à une puissance suffisante pour que la station de base correspondante puisse recevoir de façon correcte selon les spécifications en vigueur. Par exemple, lorsque cette station de base se trouve à une distance du terminal telle qu'elle ne reçoit peu ou plus les informations de communication du terminal, la station émet une indication au terminal d'émettre à une puissance supérieure déterminée par la station.

A partir de cette puissance à émettre, une table de correspondance, enregistrée par exemple dans une mémoire du terminal, fait correspondre cette puissance à une valeur prédéterminée. Le signal à émettre est fourni en entrée de l'amplificateur et une boucle prélève alors le signal de sortie de l'amplificateur de puissance pour le comparer à ladite valeur prédéterminée. Tant que celle-ci n'est pas atteinte, le comparateur influe sur l'amplificateur de puissance pour incrémenter sa puissance de sortie.

Or, la montée en puissance de l'amplificateur est différente d'un amplificateur à un autre, selon les composants qui les composent, la dérive qu'il peut subir, ...

Cet état de fait doit cependant se soumettre à l'existence de gabarits temporels définis dans des spécifications et stipulant des bornes dans lesquels la montée en puissance de l'amplificateur doit se contenir. Ainsi, si la montée en puissance s'effectue trop lentement, alors il peut se produire une perte d'informations alors qu'une montée en puissance, elle, trop rapide engendrerait une occupation spectrale importante qui se ferait au dépens des communications des autres terminaux.

En conséquence, d'après ce qui vient d'être énoncé, dans les terminaux de l'art antérieur, la montée en puissance de l'amplificateur de puissance dure un moment qui est non seulement pas déterminable mais qui peut être trop long pour que la qualité de service requise soit remplie.

La présente invention a pour objet de remédier au problème ci-dessus posé au terminal, et vise le but d'accession rapide à la puissance désirée suite à un stimulus de signal d'entrée à l'entrée de l'amplificateur de puissance déterminée.

On connait du document EP 0 434 294 un dispositif d'émission de signaux radiofréquence comprenant des moyens d'amplification de puissance destinés à amplifier la puissance d'un signal radiofréquence reçu à une entrée desdits moyens d'amplification, des moyens de contrôle du gain desdits moyens d'amplification délivrant un signal de contrôle sur une entrée de contrôle d'une tension de polarisation desdits moyens d'amplification de puissance, pour réguler ledit gain de manière à ce que la puissance du signal de sortie desdits moyens d'amplification de puissance tende vers une valeur nominale désirée, lesdits moyens de contrôle opérant en comparant un signal de commande obtenu à partir d'un signal de mesure de la puissance de sortie desdits moyens d'amplification pour délivrer ledit signal de contrôle destiné à contrôler l'évolution du gain des moyens d'amplification. Selon la présente invention, le dispositif présente en outre les caractéristiques spécifiées dans la partie caractérisante de la revendication 1.

Ainsi, le dispositif selon l'invention comportant des moyens d'ajustement autres que la boucle de régulation de l'art antérieur et réagissant plus rapidement au signal d'entrée de l'amplificateur de puissance, permet d'atteindre plus rapidement un niveau de puissance désirée à l'émission. La fonction de transfert de l'amplificateur de puissance est modifiée en ce sens.

Selon un mode de réalisation, les moyens d'ajustement ne comportent que des éléments passifs. Ainsi, les réponses à un stimulus de signal d'entrée ne peuvent que dériver très peu alors que lesdits moyens de contrôle usuels comportent des éléments actifs dont les réponses sont susceptibles de dériver.

Selon un mode de réalisation, les moyens d'ajustement comportent un pont de résistances.

Selon un mode de réalisation, les moyens d'ajustement comportent un circuit RC intégrateur.

Selon un mode de réalisation, le dispositif selon l'invention est intégré dans un appareil numérique appartenant au groupe {téléphone mobile ; assistant numérique personnel ; ordinateur portable}.

L'invention sera mieux comprise à la lecture de la description qui suit et à l'examen des figures qui l'accompagnent. Celles-ci ne sont présentées qu'à titre indicatif et nullement limitatif de l'invention. Les figures montrent :

- Figure 1 : un mode de réalisation d'un dispositif selon l'invention,
- Figure 2 : les courbes de tension aux bornes des moyens d'ajustement ainsi qu'aux bornes de l'amplificateur avec et sans les moyens d'ajustement.

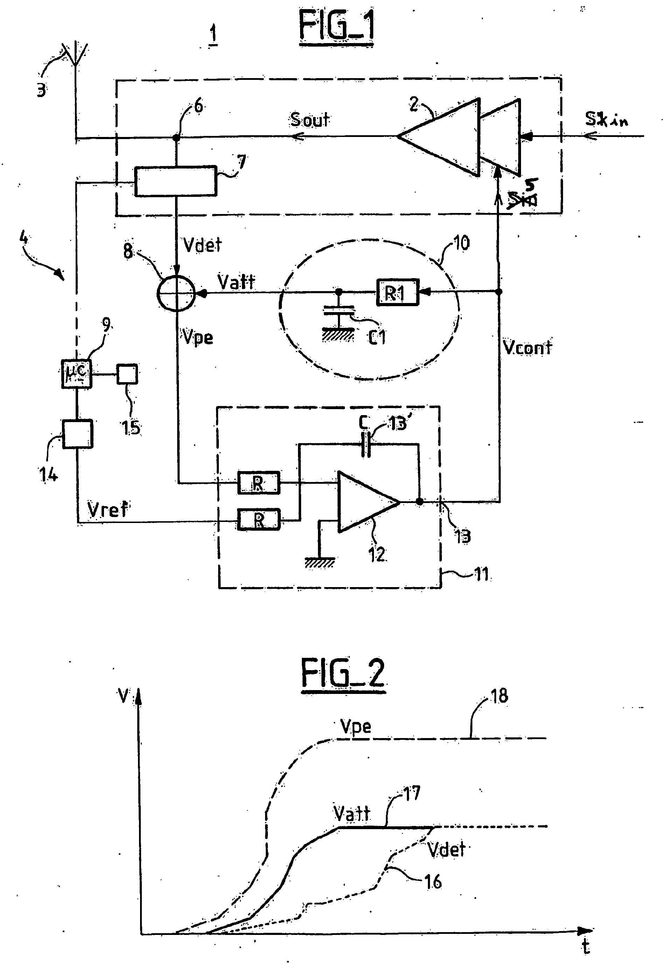

Le dispositif 1 selon un mode de réalisation de l'invention, représenté sur la figure 1, est illustré en mettant en valeur les différentes composantes fonctionnelles de l'invention.

Un amplificateur de puissance 2 reçoit un signal d'entrée Sin destiné à être amplifié. Ce signal provient de blocs de traitement en amont. Par exemple, dans le cadre d'un téléphone mobile, la parole, transmise en ondes acoustiques, est convertie en un signal analogique puis numérique. Celui-ci subit une modulation, puis une transposition de fréquence portant le signal en bande de base à une fréquence plus haute. Ce signal doit, comme on l'a vu précédemment, subir une amplification de puissance de manière à pouvoir être reçu par la station de base communicante, non représentée.

Le signal Sout de sortie de l'amplificateur est alors dirigé vers une antenne 3 pour la liaison vers la station de base.

Le signal Sout est également transmis à une boucle 4 par l'une de ses branches via une sortie 6 de l'amplificateur sortant le signal Sout.

La boucle 4 est également branchée à une entrée 5 de l'amplificateur, entrée recevant le contrôle de la tension de polarisation de l'amplificateur.

Le signal Sout entrant dans la boucle par le point 6 est transmis à un circuit de détection 7 de détection de la puissance sortie par l'amplificateur 2. Ce circuit de détection est d'une part relié en sortie à un circuit sommateur 8, d'autre part à un microcontrôleur 9 dont le rôle sera explicité par la suite. Une autre entrée du sommateur reçoit un signal provenant de la sortie d'un circuit d'ajustement 10 comprenant un circuit R1C1 d'atténuation.

Une sortie du sommateur sommant les tensions aux bornes des entrées du sommateur est reliée à une première entrée d'un bloc 11 comparateur connu en soi. Ce bloc comprend classiquement deux résistances R, l'une d'elles, celle reliée à ladite première entrée, respectivement reliée à une borne d'entrée d'un amplificateur opérationnel 12, alors que la seconde résistance R est reliée à une capacité 13'. L'autre extrémité de cette capacité est reliée à la sortie de l'amplificateur opérationnel 12. L'autre borne d'entrée de l'amplificateur est reliée à la masse. La seconde résistance est reliée, à son autre extrémité, à une seconde borne d'entrée du bloc 11. Cette seconde borne d'entrée est reliée à une sortie d'un convertisseur 14 numérique-analogique dont l'entrée est reliée à une sortie du microcontrôleur 9. Celui-ci est également reliée à une mémoire 15.

La sortie de l'amplificateur 12 est reliée à la sortie 13 du bloc 11 comparateur. Celle-ci est d'une part branchée à l'entrée du circuit 10 et d'autre part à l'entrée 5 de contrôle de la tension de polarisation de l'amplificateur de puissance 2.

Le dispositif 1 selon l'invention fonctionne de la manière suivante :

Lorsque le terminal comprenant le dispositif selon l'invention est en mode d'émission, un signal Sin à amplifier est pourvu en entrée de l'amplificateur 2. L'amplificateur va alors amplifier ce signal par bursts (pour éviter tout chauffage notamment). La norme définit des plages inférieures et supérieures d'évolution de cette puissance au cours du temps formant ainsi les gabarits de la norme.

Si le terminal doit émettre à 33 dBm par exemple, le circuit de détection 7 prélève le signal Sout et le fournit au microcontrôleur 9. La mémoire 15 comporte par ailleurs une table de correspondance qui fait correspondre une pluralité de valeurs de puissance à émettre avec une pluralité respective de valeurs numériques. Ainsi, dans le cas d'espèce, à la puissance à émettre de 33 dBm correspond une valeur numérique prédéterminée. Cette valeur est convertie en un signal analogique de référence par le convertisseur 14 appliquant une tension Vref de référence à l'une des bornes d'entrée du bloc comparateur 11.

Tant que la tension Vpe à la seconde borne d'entrée du bloc 11 comparateur est inférieure à Vref sur la première borne, le bloc 11 délivre sur sa sortie 13 une tension Vcont positive et croissante de manière à pouvoir jouer sur la tension de polarisation de l'amplificateur 2 et sur la tension aux bornes du bloc 10. Au vu des temps de réponse du bloc 10 et de l'amplificateur de puissance 2, comme on le verra dans la suite, le bloc 10 répond d'abord à la consigne Vcont (le bloc 10 est plus rapide et Vatt évolue en premier lieu), puis l'amplificateur 2 répond à la consigne (avec une réponse plus lente ; par conséquent, Vdet évolue en second lieu). La réponse Vpe évolue donc avec un temps de réponse d'abord sous l'effet de Vatt puis sous l'effet cumulé de Vdet+Vatt, ceci jusqu'à atteindre Vref.

Comme on l'a expliqué ci-dessus, dans l'art antérieur, seul le bloc comparateur 11 est agencé dans la boucle pour ajuster à la puissance désirée. Cependant, le bloc 11, dans cette configuration de l'art antérieur, n'est assujetti qu'à la commande du signal de sortie Sout de l'amplificateur de puissance. Au vu de la partie introductive de la présente demande de brevet, l'amplificateur de puissance comportant des éléments actifs dont la réponse en fréquence et/ou dans le temps peut varier, il s'ensuit que si la réponse de l'amplificateur de puissance n'est pas suffisamment rapide, le signal en sortant ne va pas commander suffisamment rapidement le bloc 11.

Selon l'invention, ceci est résolu grâce à la cellule R1C1 qui a une fonction de transfert de constante de temps

$$1 \Big/ (1 + jR1C1w)$$

adaptée pour introduire une tension supplémentaire sur le sommateur 8 de manière à ce que la tension Vpe soit amplifiée plus rapidement et indépendamment d'éléments actifs de l'amplificateur 2. Pour être efficace, le temps de réponse impulsionnel de la cellule de filtre constituée de R1 et C1 doit être inférieur au temps de réponse de l'amplificateur de puissance.

De cette sorte, la tension Vcont en sortie du comparateur 11 est également amplifiée par rapport à une tension Vdet sans la tension Vatt, ce qui influe sur l'amplificateur de puissance pour en sortir un signal Sout de puissance incrémentée amplifiée de façon plus grande que si la cellule R1C1 était inexistante.

La figure 2 illustre l'intérêt d'un tel montage. Il y est illustré l'évolution des trois tensions Vdet, Vatt et Vpe lors de la phase de démarrage de l'émission d'un signal en entrée de l'amplificateur de puissance jusqu'au régime stationnaire. Il y est ainsi illustré une première courbe 16 d'évolution de la tension Vdet détectée en sortie de l'amplificateur de puissance. Une seconde courbe 17 d'évolution de la tension Vatt de la cellule R1C1 est illustrée croissante de manière plus réactive temporellement par rapport à la courbe 16. De cette sorte, la tension Vpe, courbe 18, qui est la somme des deux dernières tensions est incrémentée beaucoup plus rapidement que sans la tension Vatt. Ceci est dû à l'adjonction de la cellule R1C1 et se comprend par la nouvelle fonction de transfert de l'ensemble, qui peut s'écrire :

$$Vpe = V\det + Vatt = (H\det .Hpa + 1 \Big/ (1 + jR1C1w)).Vcont$$

Bien entendu, l'invention n'est pas limitée aux modes de réalisation décrits ci-dessus. Ainsi, à la place ou en plus du circuit R1C1 intégrateur, on peut placer un pont de résistances. Le dispositif 1 est particulièrement adapté pour être intégré dans un appareil numérique appartenant au groupe {téléphone mobile ; assistant numérique personnel ; ordinateur portable}.

**Revendications**

1. Dispositif (1) d'émission de signaux radiofréquence comprenant des moyens d'amplification (2) de puissance destinés à amplifier la puissance d'un signal (Sin) radiofréquence reçu à une entrée desdits moyens d'amplification (2), des moyens de contrôle (11) du gain desdits moyens d'amplification (2) délivrant un signal de contrôle (Vcont) sur une entrée (5) de contrôle d'une tension de polarisation desdits moyens d'amplification (2) de puissance pour réguler ledit gain de manière à ce que la puissance du signal de sortie (Sout) desdits moyens d'amplification (2) de puissance tende vers une valeur nominale désirée (Vref), lesdits moyens de contrôle (11) opérant en comparant un signal de commande (Vpe) obtenu à partir d'un signal de mesure (Vdet) de la puissance de sortie desdits moyens d'amplification avec ladite valeur nominale désirée (Vref) pour délivrer ledit signal de contrôle (Vcont) destiné à contrôler l'évolution du gain des moyens d'amplification, **caractérisé en ce que** ledit dispositif comprend en outre :

   - des moyens d'ajustement (10) recevant en entrée ledit signal de contrôle (Vcont) et délivrant un signal d'ajustement (Vatt), et
   - un sommateur (8) pour délivrer ledit signal de commande (Vpe) résultant de la sommation du signal de mesure (Vdet) et du signal d'ajustement (Vatt),

   lesdits moyens d'ajustement (10) étant conçus pour avoir un temps de réponse inférieur au temps de réponse desdits moyens d'amplification (2) de puissance de manière à ce que ledit signal de commande (Vpe) soit apte à commander plus rapidement lesdits moyens de contrôle (11).

2. Dispositif selon la revendication 1, **caractérisé en ce que** les moyens d'ajustement (10) ne comportent que des éléments passifs.

3.  Dispositif selon la revendication 1 ou 2, **caractérisé en ce que** les moyens d'ajustement (10) comportent un pont de résistances.

4.  Dispositif selon l'une des revendications 1 à 3, **caractérisé en ce que** les moyens d'ajustement (10) comportent un circuit RC intégrateur.

5.  Dispositif selon l'une des revendications 1 à 4, **caractérisé en ce qu**'il est intégré dans un appareil numérique appartenant au groupe {téléphone mobile ; assistant numérique personnel ; ordinateur portable}.

**Claims**

1.  Device (1) for transmitting radiofrequency signals comprising power amplifying means (2) intended to amplify the power of a radiofrequency signal (Sin) received at the input of said amplifying means (2), control means (11) controlling the gain of said amplifying means (2) and delivering a control signal (Vcont) to an input (5) for controlling a polarization voltage of said power amplifying means (2) to adjust said gain so that the power of the output signal (Sout) of said power amplifying means (2) tends towards a desired nominal value (Vref), said control means (11) operating by comparing a command signal (Vpe), obtained from a signal(Vdet)measuring the output power of said amplifying means, with said desired nominal value (Vref) to deliver said control signal (Vcont) intended to control changes in gain of the amplifying means, **characterized in that** said device also comprises:

    - adjustment means (10), whose input receives said control signal (Vcont), and which deliver an adjustment signal (Vatt), and
    - a summator (8) to deliver said command signal (Vpe) resulting from the summing-up of the measurement signal (Vdet) and adjustment signal (Vatt),

    said adjustment means (10) being designed to have a shorter response time than the response time of said power amplifying means (2) so that said command signal (Vpe) is able to have quicker command over said control means (11).

2.  Device as in claim 1, **characterized in that** the adjustment means (10) only comprise passive elements.

3.  Device as in claim 1 or 2, **characterized in that** the adjustment means (10) comprise a resistance bridge.

4.  Device as in any of claims 1 to 3, **characterized in that** the adjustment means (10) comprise an integrator RC circuit.

5.  Device as in any of claims 1 to 4, **characterized in that** it is integrated in a digital apparatus belonging to the group (mobile telephone; personal digital assistant; laptop computer).

**Patentansprüche**

1.  Vorrichtung (1) zum Senden von Hochfrequenzsignalen, mit Leistungsverstärkungsmitteln (2), die dazu vorgesehen sind, die Leistung eines am Eingang der Verstärkungsmittel (2) empfangenen Hochfrequenzsignals (Sin) zu verstärken, und Mitteln (11) zum Steuern des Verstärkungsfaktors der Verstärkungsmittel (2), die an einen Steuereingang (5) für eine Vorspannung der Leistungsverstärkungsmittel (2) ein Steuersignal (Vcont) liefern, um den Verstärkungsfaktor in der Weise zu regulieren, dass die Leistung des Ausgangssignals (Sout) der Leistungsverstärkungsmittel (2) gegen einen gewünschten Nennwert (Vref) strebt, wobei die Steuermittel (11) **dadurch** arbeiten, dass sie ein aus einem Messsignal (Vdet) der Ausgangsleistung der Verstärkungsmittel erhaltenes Befehlssignal (Vpe) mit dem gewünschten Nennwert (Vref) vergleichen, um das Steuersignal (Vcont) zu liefern, das dazu bestimmt ist, die Entwicklung des Verstärkungsfaktors der Verstärkungsmittel zu steuern, **dadurch gekennzeichnet, dass** die Vorrichtung außerdem umfasst:

    - Einstellmittel (10), die am Eingang das Steuersignal (Vcont) empfangen und ein Einstellsignal (Vatt) liefern, und
    - einen Summierer (8) zum Liefern des Befehlssignals (Vpe), das aus der Summation des Messsignals (Vdet) und des Einstellsignals (Vatt) resultiert,

wobei die Einstellmittel (10) so entworfen sind, dass sie eine Ansprechzeit haben, die kleiner als die Ansprechzeit der Leistungsverstärkungsmittel (2) ist, derart, dass das Befehlssignal (Vpe) die Steuermittel (11) schneller steuern kann.

2. Vorrichtung nach Anspruch 1, **dadurch gekennzeichnet, dass** die Einstellmittel (10) nur passive Elemente enthalten.

3. Vorrichtung nach Anspruch 1 oder 2, **dadurch gekennzeichnet, dass** die Einstellmittel (10) eine Widerstandsbrücke enthalten.

4. Vorrichtung nach einem der Ansprüche 1 bis 3, **dadurch gekennzeichnet, dass** die Einstellmittel (10) eine RC-Integratorschaltung enthalten.

5. Vorrichtung nach einem der Ansprüche 1 bis 4, **dadurch gekennzeichnet, dass** sie in ein digitales Gerät integriert ist, das zu der Gruppe {Mobiltelephon; persönlicher digitaler Assistent; tragbarer Rechner} gehört.

# FIG_1

# FIG_2